(19) Europäisches Patentamt / European Patent Office / Office européen des brevets

(11) **EP 2 300 657 B1**

(12) **EUROPEAN PATENT SPECIFICATION**

(45) Date of publication and mention of the grant of the patent:
**15.02.2017 Bulletin 2017/07**

(51) Int Cl.:
*D06M 11/83* (2006.01)    *A01N 25/34* (2006.01)
*A01N 59/16* (2006.01)    *C23C 14/20* (2006.01)
*C23C 14/56* (2006.01)

(21) Application number: **09776455.9**

(22) Date of filing: **19.03.2009**

(86) International application number:
**PCT/EP2009/002050**

(87) International publication number:
**WO 2010/006664 (21.01.2010 Gazette 2010/03)**

(54) **SILVER-COATED WOVENS AND NONWOVENS COMPRISING POLYOLEFIN FIBRES**

SILBERBESCHICHTETE WEB- ODER VLIESSTOFFE ENTHALTEND POLYOLEFINFASER

ÉTOFFES TISSÉES ET ÉTOFFES NON-TISSÉES COMPRENANT DES FIBRES DE POLYOLÉFINE REVÊTUES D'ARGENT

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **16.07.2008 EP 08012850**

(43) Date of publication of application:
**30.03.2011 Bulletin 2011/13**

(73) Proprietor: **Borealis AG**
**1220 Vienna (AT)**

(72) Inventors:
• **BROEDERS, Bert**
 **B-3580 Beringen (BE)**
• **VAN PARIDON, Henk**
 **B-3271 Averbode (BE)**

• **ACKERMANS, Nina**
 **B-3980 Tessenderlo (BE)**

(74) Representative: **Kador & Partner**
**Corneliusstraße 15**
**80469 München (DE)**

(56) References cited:
**DE-A1- 2 146 103    US-A- 5 316 837**

• **DATABASE WPI Week 200207, Derwent Publications Ltd., London, GB; AN 2002-051320 & JP 2001 248066 A (SUPATTA KK) 14 September 2001**

Remarks:
The file contains technical information submitted after the application was filed and not included in this specification

**Description**

The present invention relates to a process for coating polyolefin fibres with a metal, and to the product of such a process, namely a metal-coated polyolefin fibre, and further to wovens or nonwovens comprising said metal-coated polyolefin fibers.

It is known that silver is used to award several articles antimicrobial properties. Particularly, it is known that such antimicrobial properties are typically achieved for articles made of polyolefins by means of silver-based masterbatches, i.e. the polyolefin is compounded with a masterbatch containing silver particles. Due to the size of said silver particles the application of such silver particles is limited. Having a particle size of about 1 $\mu$m, such a particle is too large for very fine fibres which itself have a very small diameter. The diameter of a fine polyolefin fibre may be typically less than 2 $\mu$m. Adding a masterbatch containing silver particles as described above to a polyolefin composition and producing such a fine fibre thereof causes problems in the process of producing the fibre and may also cause problems in case of a process of spinning the fibres to yarns for wovens respectively. Further on, a poor distribution of said particles in said fibre results. Hence, there is a strong need for a technique which allows to make fine fibres and thereby wovens or nonwovens antimicrobial.

In this regard it has been suggested to incorporate nanosilver components which however are rather expensive. Hence, there is also a need for a cheaper technique which allows to make fine fibres antimicrobial.

A survey of antibacterial activity of polypropylene compounded with nano-sized silver powders is given in Journal of Materials Science 2006, 40, 20, 5407-5411.

It is also known to coat a substrate with silver by using a chemical reaction wherein cations of silver are reduced by organic reducing agents. A study of antibacterial properties of silver nano-coated cotton fabrics received by such a chemical reaction is described in "A practical procedure for producing silver nanocoated fabric and its antibacterial evaluation for biomedical applications" (Chem. Commun. (Camb). 2007 Jul 28;(28):2959-61. Epub 2007 May 18). A similar study is given in Textile Research Journal 2006, 76, 57-65. The disadvantage of such processes is that apart from the silver layer further products result from the chemical reaction which have to be separated and involve further effort which should be avoided in a technical process due to the costs involved.

It is further known to coat fabrics with silver by using a plasma-process or plasma-sputtering process. Such a process is described in Curr. Probl. Dermatol. 2006, 33, 179-199. A disadvantage of this process is again the high costs that are involved.

Hence, there is still a need for a reliable and cheap process which makes polyolefin fibres antimicrobial.

However, not only a process of adding silver to polyolefin fibres in view of antimicrobial properties is desirable. There are many applications thinkable for polyolefin fibres as well as wovens or nonwovens comprising said polyolefin fibres wherein the addition of silver or a metal other than silver is needed. Examples are filter media with permanent electrical charge for combined mechanical filtration and charged attraction or electrical conductivity and anti-static performance in general as well as thermal insulation and heat reflection. In case antimicrobial properties are not needed, e.g. aluminium could be desirable.

The problem is again to provide a reliable and comparably cheap process for adding a metal to a polyolefin fibre which process does not affect the process of producing the polyolefin fibre or rather the process of spinning.

From DE 2 146 103 is known a laminated sheet plastic material for use as a reflective material in heat and cold insulation, as electrically conductive material, as protective clothing, linings, etc., comprising layers of plastic material and metal. The substrate consists of an endless polypropylene or polyamide fibrous fleece that is heat-sealed on one or both sides. A metal, e.g. Al, layer of 0.01-0.1 $\mu$m is applied to the hot-sealed side(s) of the fleece, preferably by vapour-deposition.

From US 5 314 837 is known a stretchable metallized nonwoven web composed of at least one nonwoven web of non-elastomeric thermoplastic polymer fibers, the nonwoven web having been heated and then necked so that it is adapted to stretch in a direction parallel to neck-down at least about 10 percent more than an identical untreated nonwoven web of fibers; and a metallic coating substantially covering at least a portion of at least one side of the nonwoven web. The nonwoven web of non-elastomeric thermoplastic polymer fibers can be a nonwoven web of non-elastomeric meltblown thermoplastic polymer fibers. The stretchable metallized nonwoven web may be joined with other materials to form multi-layer laminates. Also disclosed is a process of making a stretchable metallized nonwoven web.

JP 2001 248 066 A deals with the problem to obtain a cloth having sterilizing and antimicrobial effects, maintaining the effects, having high safety to the human body being stuck with a sterilizing antimicrobial metal. This problem is solved by a nonwoven fabric or a woven fabric of a substrate which is stuck with a sterilizing and antimicrobial metal by a sputtering method. When the nonwoven fabric or the woven fabric is applied to the injury part of the human body, a metal ion is oozed out to control breeding of various germs, to keep a hygienic state and to promote recovery of a wound part.

It is finally known to coat biaxially orientated polypropylene (BOPP) films with a metal by a thermal vaporization process. This process is widely used in the packaging industry. However, the BOPP films have to be pretreated by either corona or flame treatments. Said pretreatment is absolutely necessary since otherwise the metal does not adhere on the film surface. This pre-treatment is done in-line in the film production. A disadvantage of said pretreatment is that it generates additional costs. In case of non-wovens the prorosity would not allow a corona treatment.

The above-mentioned problems are solved by a process according to claim 1 which describes the surface coating of a polyolefin fibre with a metal being silver.

It has been surprisingly found that surface coating of polyolefin fibres is possible by a thermal vaporization process without the need of a pretreatment as required for BOPP films.

Accordingly, the present invention provides a thermal vaporization process for coating of polyolefin fibres with a metal, wherein said process comprises the following steps:

- inserting a polyolefin fibre or a woven or nonwoven comprising polyolefin fibres into a metallisation chamber comprising a heating means located next to a piece of metal,

- applying a high vacuum in said chamber

- applying heat by said heating means to said piece of metal whereby the metal evaporates and is deposited onto the colder surface of said polyolefin fibre or woven or nonwoven comprising polyolefin fibres

- removing the coated fibre or woven or nonwoven comprising polyolefin fibres from said metallisation chamber,

whereby the fibre to be coated with metal is made of a polypropylene composition or of a polyethylene composition, including copolymers of propylene or ethylene with other alpha-olefins comprising from 3 to 6 carbon atoms, wherein the metal is silver and wherein the diameter of the polyolefin fibre to be coated is from 0.1 to 30 $\mu$m.

With the inventive process it is possible to provide polyolefin fibres comprising silver atoms without negatively affecting the process of producing the polyolefin fibres. One further advantage of the inventive process is that the silver atoms are only at the location where they should be for awarding antimicrobial, antistatic or rather electrical properties to the polyolefin fibre or rather the woven or nonwoven, namely on the surface of the polyolefin fibres. Hence, no silver is "lost" which is inside the bulk of the polyolefin fibre and has therefore no effect as regards said properties of the polyolefin fibre. As a consequence, less silver can be used compared to known processes using a metal masterbatch. Therefore, the inventive process provides a cheaper and also more effective alternative to the known processes using metal masterbatches. Finally, the thermal vaporization process is also cheaper than plasma sputtering and does not have any problems of by-products as in chemical coating reactions.

There is also a great advantage in view of a process wherein silver particles are compounded with the polyolefin composition from a practical point of view: No transition in the fibre production process is necessary. Instead, the metalliser can simply be switched on or off while using a metal masterbatch it is necessary to purge the line if the product is changed from fibres containing a metal masterbatch to fibres which do not contain such a masterbatch. Further on, using the inventive process the equipment already available for surface coating of BOPP films may be used.

A thermal vaporization process is known to be generally applicable with aluminium, copper, silver and zinc. The metals that can be used depend on the thermal vaporization temperature of the respective metal and on the pressure in the metallisation chamber. Further on, the vapour pressure of the metal to be used must be considerably higher than the vapour pressure of the material the heating means is made of. Otherwise contamination of the metal layer to be produced with the material of the heating means has to be expected.

The metal to be used in the inventive process is silver.

Preferably the heating means is an electric resistance heater, more preferably a metal spiral.

Preferably the heating means is made of steel.

The metal to be coated onto the polyolefin fibre is silver.

Preferably the piece of metal is a wire.

Preferably the pressure in the metallisation chamber under high vacuum is between 1 to 10 mPa, more preferably between 3 to 7 mPa.

The inventive process is preferably run batchwise.

This means that a polyolefin fibre, sample of polyolefin fibres, a woven or a nonwoven is placed into a sealed-off metallisation chamber. The chamber is closed and high vacuum is applied. Afterwards heating with the heating means is started. After a given time the heating is stopped and the metallisation chamber is vented. The time of heating depends on the dimensions of the substrate to be coated with metal.

Preferably, the substrate - a fibre, a woven or nonwoven - is provided in a furled manner. The substrate is unwound in the metallisation chamber under the metallisation conditions, runs over the metal vapour that is generated in the metallization chamber and is coiled up at the other side. The polyolefin substrate coated with metal is removed and the metallisation chamber is ready for a new cycle.

The inventive process is carried out with a fibre made of a polypropylene composition or of a polyethylene composition, including copolymers of propylene or ethylene with other alpha-olefins comprising from 3 to 6 carbon atoms.

Preferred is a polypropylene composition.

The polyolefin composition, if it is predominantly or exclusively comprised of polypropylene, which is to be used for the polyolefin fibre to be treated with metal according to the present invention, preferably has an $MFR_2$ (230 °C) of between 12 and 3000 g/10 min, more preferably between 12 and 2000 g/10 min.

The polyolefin composition, if it is predominantly or exclusively comprised of polyethlyene, which is to be used for the polyolefin fibre to be treated with metal according to the present invention, preferably has an $MFR_2$ (190 °C) of between 0.2 and 1000 g/10 min, more preferably between 0.4 and 500 g/10 min.

A polyolefin fibre to be coated according to the present invention has a diameter of 0.1 to 30 $\mu$m, preferably of 1 to 10 $\mu$m.

The polyolefin composition may comprise additives, i.e. stabilizers and modifiers. Typical stabilizers are antioxidants, typical modifiers are anti-static and anti-fogging agents, acid scavengers, blowing agents, lubricants, nucleating agents, slip and anti-blocking agents, as well as fillers, flame retardants and cross-linkers. The polyolefin composition may also comprise pigments.

It is further preferred that the nonwovens according to the invention are received from polyolefin fibres by meltblown, spunbond, spunbond-meltblown-spunbond (SMS), carding, airlaid or any other web formation process, more preferably by a meltblown process.

It is further preferred that the wovens according to the invention are received from polyolefin fibres by meltblown or spunbond processes, more preferably by a meltblown process.

The present invention is also directed to a breathable woven or nonwoven comprising polyolefin fibres coated with a metal received by the inventive process.

The products of the inventive process show only a coating of silver on the fibres. If the process is not applied on a single fibre but on a woven or nonwoven comprising polyolefin fibres, the pores between said fibres are not covered with silver resulting in a breathable metallised structure, e.g. a fabric.

As regards the type of polyolefin composition and the fibres, the woven or nonwoven, as well as the metal used for coating, the same preferred embodiments apply as for the inventive process.

The present invention not falling under the scope of the claims is also directed to a polyolefin fibre comprising a surface coating of metal with a thickness of between 0.1 to 100 nm, to a woven or nonwoven made from such coated polyolefin fibres and to a woven or nonwoven comprising polyolefin fibres wherein the surface of said polyolefin fibres is coated with a metal and the thickness of said coating is between 0.1 to 100 nm.

As regards the type of polyolefin composition and the fibres, the woven or nonwoven, as well as the metal used for coating, the same preferred embodiments apply as for the inventive process.

**Measurement methods**

a) Melt Flow Rate

The melt flow rate (MFR) is determined according to ISO 1133 and is indicated in g/10 min. The MFR is an indication of the melt viscosity of the polymer. The MFR is determined at 190 °C for PE and at 230 °C for PP. The load under which the melt flow rate is determined is usually indicated as a subscript, for instance $MFR_2$ is measured under 2.16 kg load.

b) Density

The density of polymer compositions was measured according to ISO 1183/D.

c) Determination of antibacterial activity

The tests where performed according to ISO/FDIS 20743 : 2007. These tests are used to quantitatively measure the antimicrobial activity of antibacterial finished samples.

The test samples (inventive, silver coated) and control samples (comparative, no metal coating) are cut into pieces of 3.8 cm in diameter. Afterwards the inoculation is performed by transfer of bacteria from agar plate onto the samples. Each test sample as well as each control sample is placed on the agar surface of an agar plate that has been previously inoculated by first flooding the agar surface with 1 ml of a bacterial suspension adjusted to a concentration of $1 \times 10^6$ to $3 \times 10^6$ CFU/ml and then sucking up as much of the excess liquid as possible. A weight of 200 g is applied on the sample for 60 seconds and the sample is afterwards placed in a petri dish with the transferred surface face up.

Six test samples in individual petri dishes plus six separate petri dishes with control samples constitute one test.

Immediately after transfer (so-called "0 contact time"), three of the six test samples and three of the six control samples are each placed in a vial containing a neutralizing solution (one vial/sample) and are shaken out to extract the bacteria present on them. A counting of the extraction liquid is performed by the Plate Count Method.

The remaining test samples and control samples are incubated in their petri dishes in a humidity chamber at 37 °C for 18 to 24 hours.

After incubation, extraction and counting of the bacteria present on the remaining test samples or rather control samples is performed as described above for the "0 contact time". The growth value and the activity values are computed afterwards.

The growth value is computed as follows:

$$F = C_t - C_0$$

$F$ :     growth value of the control sample

$C_t$ :     average of decadic logarithms of the number of bacteria obtained from three control samples after 18 to 24 hours incubation

$C_0$ :     average of decadic logarithms of the number of bacteria obtained from three control samples immediately after transfer to the control samples

The test is judged to be effective, if the growth value is > 1 for the control sample and if the logarithm of the difference in extremes of the value of number of bacteria for the three control samples immediately after transfer as well as after incubation is not more than 1.

The activity value is computed as follows:

$$A = (C_t - C_0) - (T_t - T_0) = F - G$$

$A$ :     antibacterial activity value

$F$ :     growth value of the control sample

$G$ :     growth value of the test sample

$T_t$ :     average of decadic logarithms of the number of bacteria obtained from three test samples after 18 to 24 hours incubation

$T_0$ :     average of decadic logarithms of the number of bacteria obtained from three test samples immediately after transfer to the test samples

**Examples**

a) Preparation of meltblown samples

Meltblown fabric samples were produced on a REICOFIL® MB 250 meltblown laboratory line using a propylene homopolymer having an $MFR_2$ (230 °C) of 1200 g/10 min. Line speed of the meltblown line was 10 m/min, corresponding with a throughput of 30 kg/(m · min) and resulting in an area weight of ca. 50 g/m$^2$. The average fiber diameter was 5 $\mu$m (range of 4-6 $\mu$m).

b) Step of metallisation

Samples from the meltblown line have been metallised with silver using a laboratory metalliser (AUTO 306 Coater of the brand Edwards having a FL400 vacuum chamber with see-through window and 10 volts transformer).

A flat sheet of substrate (meltblown nonwoven) to be coated with a metal is cut to fit into a metal holder. Said holder consists of two steel frames that fit into each other. The substrate is clamped between the frames and is such stabilized.

The holder with the substrate is placed into the metallisation chamber. Within said metallisation chamber there is a steel spiral that can be heated by an electric current. A piece of a metal wire of the material to be deposited with a weight of 75 mg +/- 1 mg is inserted inside said spiral.

The chamber is closed and brought under high vacuum. As soon as the pressure in the chamber reaches 6.5 $\times$ 10$^{-5}$ mbar, the steel spiral is heated. The wire (aluminium or silver) evaporates and is deposited onto colder surfaces as the substrate. The evaporation is allowed to take place 10 seconds.

Afterwards the heating of the steel spiral is (automatically) switched off and the pressure is brought to atmospheric pressure by venting the chamber. Finally, the metallised sample is removed.

c) Antimicrobial performance of silver-coated samples

The antimicrobial performance of samples coated with silver as described under paragraph a) above has been tested by Centexbel. (Centexbel is a certified laboratory. Centexbel is the scientific and technological research centre of the Belgian textile industry.) As a result the substrate treated with silver showed good antimicrobial activity against Staphylococcus aureus and Klebsiella pneumoniae as will be explained in detail below.

The strains used in the Examples were the following:

Klebsiella pneumoniae ATCC 4352

Staphylococcus aureus ATCC 6538

The test was performed as described above under measurement methods, c). In addition to the six test samples and the six control samples also an internal control with a cotton fabric (200 g/m$^2$) has been used (EMPA Nr. 221, which is a commercially available testfabric, which is 100 % cotton-based).

1 ml of the inoculum solution was used to flood the agar surface of the transfer agar plate: Peptone-salt solution (Tryptone, pancreatic digest of casein: 1 g/l, NaCl: 8.5 g/l), 1 ml was used.

20 ml of the neutralizing solution was used: Polysorbate 80: 30 g/l, Lecithin: 3 g/l, Histidine hydrochloride: 1 g/l, Peptone: 1 g/l, NaCl: 4.3 g/l, Mono-potassium phosphate: 3.6 g/l, Disodium phosphate dihydrate: 7.2 g/l.

The contact time was 18 hours (at 37 °C).

Microbiological technique used for the determination of the viable cells: count of number of colonies of dilution series on Petri dishes (Plate Count Method).

**Example 1**

The tests were performed with Staphylococcus aureus ATCC 6538. The inoculum concentration was 2.6 $\times$ 10$^6$ CFU/ml.

Table 1 shows the control of the growth value obtained on the control samples (CFU: colony forming unit).

Table 2 shows the count of bacteria on the samples, both growth values and the resulting antibacterial activity value.

Table 1:

| Sample | Trial | 0 contact time | | 18 hours contact time | |
|---|---|---|---|---|---|
| | | CFU | $\log_{10}$(CFU) | CFU | $\log_{10}$(CFU) |
| Control | 1 | $3.2 \times 10^5$ | 5.51 | $2.8 \times 10^6$ | 6.45 |
| Control | 2 | $3.8 \times 10^5$ | 5.58 | $2.2 \times 10^6$ | 6.34 |
| Control | 3 | $3.6 \times 10^5$ | 5.56 | $2.2 \times 10^6$ | 6.34 |
| Average | | | $5.6 \pm 0.04$ | | $6.4 \pm 0.06$ |
| Growth value $F$ | | | | | **0.8** |
| | | | | | |
| Internal control | 1 | $3.6 \times 10^5$ | 5.56 | $1.1 \times 10^7$ | 7.03 |
| | 2 | $4.2 \times 10^5$ | 5.62 | $1.9 \times 10^7$ | 7.27 |
| Average | | | $5.6 \pm 0.04$ | | $7.2 \pm 0.17$ |
| Growth value $F$ | | | | | **1.6** |

The growth value of the control samples is a little bit too low but still acceptable.

Table 2:

| Sample | Trial | 0 contact time | | 18 hours contact time | |
|---|---|---|---|---|---|
| | | CFU | $\log_{10}$(CFU) | CFU | $\log_{10}$(CFU) |
| Control | 1 | $3.2 \times 10^5$ | 5.51 | $2.8 \times 10^6$ | 6.45 |
| Control | 2 | $3.8 \times 10^5$ | 5.58 | $2.2 \times 10^6$ | 6.34 |
| Control | 3 | $3.6 \times 10^5$ | 5.56 | $2.2 \times 10^6$ | 6.34 |
| Average | | | $5.6 \pm 0.04$ | | $6.4 \pm 0.06$ |
| Growth value $F$ | | | | | **0.8** |
| | 1 | $3.4 \times 10^5$ | 5.53 | 0[1] | 0[1] |
| | 2 | $4.0 \times 10^5$ | 5.60 | 0[1] | 0[1] |
| | 3 | $3.6 \times 10^5$ | 5.56 | 0[1] | 0[1] |
| Average | | | $5.6 \pm 0.04$ | | 0 |
| Growth value $G$ | | | | | **-5.6** |
| Antibacterial activity $A$ | | | | | **6.4** |

[1] "0" means that no colony has been counted. If no colony is counted, $\log_{10}$(CFU) is arbitrarily fixed to "0".

**Example 2**

The tests were performed with Klebsiella pneumoniae ATCC 4352. The inoculum concentration was $2.5 \times 10^6$ CFU/ml.

Table 3 shows the control of the growth value obtained on the control samples (CFU: colony forming unit).

Table 4 shows the count of bacteria on the samples, both growth values and the resulting antibacterial activity value.

Table 3:

| Sample | Trial | 0 contact time | | 18 hours contact time | |
|---|---|---|---|---|---|
| | | CFU | $\log_{10}$(CFU) | CFU | $\log_{10}$(CFU) |
| Control | 1 | $2.0 \times 10^5$ | 5.30 | $7.4 \times 10^5$ | 5.87 |
| Control | 2 | $1.8 \times 10^5$ | 5.25 | $3.6 \times 10^5$ | 5.56 |
| Control | 3 | $1.9 \times 10^5$ | 5.28 | $2.8 \times 10^6$ | 6.45 |
| Average | | | $5.3 \pm 0.03$ | | $6.0 \pm 0.45$ |
| Growth value $F$ | | | | | **0.7** |
| Internal control | 1 | $2.0 \times 10^5$ | 5.29 | $2.4 \times 10^8$ | 8.38 |
| | 2 | $2.4 \times 10^5$ | 5.38 | $9.0 \times 10^7$ | 7.95 |
| Average | | | $5.3 \pm 0.06$ | | $8.2 \pm 0.30$ |
| Growth value $F$ | | | | | **2.9** |

The growth value of the control samples is a little bit too low but still acceptable.

Table 4:

| Sample | Trial | 0 contact time | | 18 hours contact time | |
|---|---|---|---|---|---|
| | | CFU | $\log_{10}$(CFU) | CFU | $\log_{10}$(CFU) |
| Control | 1 | $2.0 \times 10^5$ | 5.30 | $7.4 \times 10^5$ | 5.87 |
| Control | 2 | $1.8 \times 10^5$ | 5.25 | $3.6 \times 10^5$ | 5.56 |
| Control | 3 | $1.9 \times 10^5$ | 5.28 | $2.8 \times 10^6$ | 6.45 |
| Average | | | $5.3 \pm 0.03$ | | $6.0 \pm 0.45$ |
| Growth value $F$ | | | | | **0.7** |

(continued)

| Sample | Trial | 0 contact time | | 18 hours contact time | |
|---|---|---|---|---|---|
| | | CFU | $\log_{10}$(CFU) | CFU | $\log_{10}$(CFU) |
| | 1 | $1.6 \times 10^5$ | 5.20 | 0[1] | 0[1] |
| | 2 | $1.1 \times 10^5$ | 5.04 | 0[1] | 0[1] |
| | 3 | $2.0 \times 10^5$ | 5.30 | 0[1] | 0[1] |
| Average | | | $5.2 \pm 0.13$ | | 0 |
| Growth value $G$ | | | | | **-5.2** |
| Antibacterial activity $A$ | | | | | **5.9** |

[1] "0" means that no colony has been counted. If no colony is counted, $\log_{10}$(CFU) is arbitrarily fixed to "0".

**Claims**

1. A thermal vaporization process for coating of polyolefin fibres with a metal, wherein said process comprises the following steps:

    - inserting a polyolefin fibre or a woven or nonwoven comprising polyolefin fibres into a metallisation chamber comprising a heating means located next to a piece of metal,
    - applying a high vacuum in said chamber
    - applying heat by said heating means to said piece of metal whereby the metal evaporates and is deposited onto the colder surface of said polyolefin fibre or woven or nonwoven comprising polyolefin fibres
    - removing the coated fibre or woven or nonwoven comprising polyolefin fibres from said metallisation chamber,

    whereby the fibre to be coated with metal is made of a polypropylene composition or of a polyethylene composition, including copolymers of propylene or ethylene with other alpha-olefins comprising from 3 to 6 carbon atoms, wherein the metal is silver
    and
    the diameter of the polyolefin fibre to be coated is from 0.1 to 30 $\mu$m.

2. The process according to claim 1, wherein said heating means is an electric resistance heater.

3. The process according to any one of the preceding claims, wherein the pressure in said metallisation chamber under high vacuum is between 1 to 10 mPa.

4. The process according to any one of the preceding claims, wherein the polyolefin fibres have been received from a meltblown process.

5. A breathable woven or nonwoven comprising polyolefin fibres coated with a metal received by a process according to any one of claims 1 to 4.

**Patentansprüche**

1. Thermisches Verdampfungsverfahren zum Beschichteten von Polyolefinfasern mit einem Metall, wobei das Verfahren die folgenden Schritte umfasst:

    - Einführen von einer Polyolefinfaser oder von einem Web- oder Vliesstoff, der Polyolefinfasern umfasst, in eine Metallisierungskammer, die ein Heizmittel umfasst, das neben einem Metallstück angeordnet ist,
    - Anlegen von einem Hochvakuum in der Kammer,
    - Anwenden von Wärme auf das Metallstück durch das Heizmittel, wodurch das Metall verdampft und auf der kälteren Oberfläche der Polyolefinfaser oder des Web- oder Vliesstoffs, der Polyolefinfasern umfasst, abgeschieden wird,
    - Entfernen der beschichteten Faser oder des Web- oder Vliesstoffs, der Polyolefinfasern umfasst, aus der Metallisierungskammer,

wobei die Faser, die beschichtet werden soll, aus einer Polypropylenzusammensetzung oder einer Polyethylenzusammensetzung hergestellt ist, einschließlich von Copolymeren aus Propylen oder Ethylen mit anderen alpha-Olefinen, die 3 bis 6 Kohlenstoffatome umfassen,
wobei das Metall Silber ist,
und
der Durchmesser der Polyolefinfaser, die beschichtet werden soll, 0,1 bis 30 μm beträgt.

2. Verfahren nach Anspruch 1, wobei das Heizmittel ein elektrischer Widerstandsheizkörper ist.

3. Verfahren nach einem der vorhergehenden Ansprüche, wobei der Druck in der Metallisierungskammer unter Hochvakuum zwischen 1 und 10 mPa beträgt.

4. Verfahren nach einem der vorhergehenden Ansprüche, wobei die Polyolefinfasern aus einem Schmelzblasverfahren erhalten werden.

5. Atmungsaktive Web- oder Vliesstoffe, die Polyolefinfasern umfassen, die mit einem Metall beschichtet sind, erhalten durch ein Verfahren nach einem der Ansprüche 1 bis 4.

**Revendications**

1. Procédé de vaporisation thermique pour le revêtement de fibres de polyoléfine avec un métal, dans lequel ledit procédé comprend les étapes suivantes consistant à :

   - insérer une fibre de polyoléfine ou un tissé ou un non-tissé comprenant des fibres de polyoléfine dans une chambre de métallisation comprenant un moyen de chauffage situé à proximité d'une pièce de métal,
   - appliquer un vide puissant dans ladite chambre,
   - appliquer de la chaleur par le biais dudit moyen de chauffage à ladite pièce de métal, le métal s'évaporant ainsi et se déposant sur la surface plus froide de ladite fibre de polyoléfine dudit tissé ou non tissé comprenant des fibres de polyoléfine,
   - retirer la fibre revêtue ou le tissé ou le non tissé comprenant des fibres de polyoléfine revêtu de ladite chambre de métallisation,

   dans lequel la fibre à revêtir avec le métal est constituée d'une composition de polypropylène ou d'une composition de polyéthylène, comprenant des copolymères de propylène ou d'éthylène et d'autres alpha-oléfines comprenant de 3 à 6 atomes de carbone,
   dans lequel le métal est de l'argent,
   et
   le diamètre de la fibre de polyoléfine à revêtir est de 0,1 à 30 μm.

2. Procédé selon la revendication 1, dans lequel ledit moyen de chauffage est un moyen de chauffage à résistance électrique.

3. Procédé selon l'une quelconque des revendications précédentes, dans lequel la pression dans ladite chambre de métallisation sous un vide puissant est de 1 à 10 mPa.

4. Procédé selon l'une quelconque des revendications précédentes, dans lequel les fibres de polyoléfine sont obtenues par un procédé de fusion-soufflage.

5. Tissé ou non tissé perméable à l'air comprenant des fibres de polyoléfine revêtues d'un métal obtenues par un procédé selon l'une quelconque des revendications 1 à 4.

**EP 2 300 657 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- DE 2146103
- US 5314837 A
- JP 2001248066 A

### Non-patent literature cited in the description

- *Journal of Materials Science,* 2006, vol. 40 (20), 5407-5411
- A practical procedure for producing silver nanocoated fabric and its antibacterial evaluation for biomedical applications. *Chem. Commun. (Camb).,* 28 July 2007, vol. 28, 2959-61
- *Textile Research Journal,* 2006, vol. 76, 57-65
- *Curr. Probl. Dermatol.,* 2006, vol. 33, 179-199
- *ISO/FDIS,* 2007, vol. 20743